# EUROPEAN PATENT APPLICATION

(11) **EP 3 657 917 A1**
(43) Date of publication of application: **27.05.2020**
(21) Application number: 18208190.1
(22) Date of filing: 24.11.2018
(51) Int. Cl.: H05K 3/18, C23C 18/16, C23C 18/20, H05K 3/38, H05K 1/03

(54) **FLEXIBLE PRINTED CIRCUIT AND METHOD FOR MANUFACTURING THE SAME**

(71) Applicant: BGT Materials Limited, Manchester M13 9PL (GB)
(72) Inventor: KU, Kuanlin, 324 Taoyuan City (TW); CHANG, KUO-HSIN, 622 DALIN TOWNSHIP (TW); LAI, CHUNG-PING, 302 ZHUBEI CITY (TW)
(74) Representative: Cabinet Chaillot

(57) **Abstract**

A flexible printed circuit and a method for manufacturing the same are revealed. Modified functionalized graphene is used to prepare a functionalized graphene-based ink. Then the functionalized graphene-based ink is printed on a surface of a flexible plastic substrate to form a conductive trace pattern of a circuit. A layer of deposited copper is formed on a surface of the functionalized graphene-based ink by chemical copper plating. Since the functionalized graphene-based ink is used as catalyst for electroless copper plating, no hexavalent chromium (chromium (VI)) and palladium are required. Thus the present method has the advantages of environmental protection and low cost. The conductive trace pattern formed by the functionalized graphene-based ink has excellent adhesive capacity and higher flexibility so that it can be securely attached to the surface of the flexible plastic substrate and used as an adhesive between the copper deposition and the flexible plastic substrate.

## Description

### BACKGROUND OF THE INVENTION

### Field of the Invention

The present invention relates to a flexible printed circuit (FPC), especially to a flexible printed circuit and a method for manufacturing the same.

### Description of Related Art

Flexible copper clad laminates (FCCL) and flexible insulating layers are attached to each other by adhesives, and then treated by a lamination process and an etching process. Next a conductive trace formed is used as power transmission medium or electronic-signal transmission medium. The FPC is used in a wide range of applications such as computers and peripherals, communication products, consumer electronics, vehicles, military hardware, etc. The communication products account for the largest proportion. There are two kinds of materials used for the flexible insulating layer of FPC including polyimide film (PI film) and polyethylene terephthalate film (PET film). The PI film is the most common material.

FCCL types can be categorized into 2-layer FCCL (adhesiveless flexible copper clad laminates) and 3-layer FCCL (adhesive-based flexible copper clad laminates) depending on the adhesive that bonds the copper foil to the PI film. Owing to the adhesive, the 3-layer FCCL can be only processed by a heat treatment for quite a short period. The heat treatment results in degradation of the adhesive so that the reliability is further reduced. The adhesive also has other problems such as film stress, migration of copper atoms, plating solution infiltration, etc. By contrast, the 2-layer FCCL doesn't have these problems.

The 2-layer FCCL is mainly produced by the following methods-casting, lamination, sputtering/plating and electroless plating. During the casting, a polyimide vanish is coated on a thin copper layer and then is heated over 300°C for performing polyimide condensation to get the adhesive-free 2-layer FCCL. The 2-layer FCCL made by casting has excellent adhesion between the PI film and the copper layer. Lamination is the process of using high temperature and high pressure to attach the thermoplastic PI film to the copper foil and the production cost is higher than other methods. With the sputtering/plating method, a copper layer is directly deposited on a polyimide film. The adhesion between the deposited copper and the PI film is the smallest among the products made by the three methods. In the manufacture of printed circuit boards, electroless copper plating is used to form conductive circuits on surface of a non-metal substrate thereof. First the substrate surface is treated with a catalyst so that a layer of active particles is attached to the surface of the non-metal substrate. The step is generally called sensitization. The active particles commonly used are made from palladium (Pd) and silver (Ag). An available catalyst containing Pd particles is an aqueous solution with Pd/Sn colloids consisting of a metallic Pd core surrounded by a stabilizing layer of Sn ions (II). However, the colloidal catalyst has the shortcomings of poor Pd/Sn complex stability and high cost of palladium. During production of 2-layer FCCL, the adhesion and the flexibility between the PI film and the copper foil are the main technical problems that need to be solved.

Among the above methods, the sputtering and the electroless plating methods use nickel as a catalyst for the electorless deposition of copper. The deposited copper loses the adhesion to the film without nickel pretreatment. In the following etching process, nickel is difficult to be etched by traditional etching chemicals. Moreover, the composition of the pretreatment solution is quite important. For better handling of the used pretreatment solution, the amount of the hexavalent chromium (chromium (VI)) compounds should be reduced and reduction products should be neutralized. The hexavalent chromium compounds are genotoxic carcinogens extremely dangerous for human health. Workers exposed to hexavalent chromium compounds are at increased risk of developing lung cancer, asthma, or damage to the nasal epithelia and skin. Within America, European and China, the use of hexavalent chromium in electronics industry is largely prohibited. During neutralization, a large amount of chromium (III) hydroxide is generated and this impedes the removal of the composition used. Furthermore, the pretreatment solution used is highly corrosive so that a lot of water is required for removing the pretreatment solution from the surface of the non-metal substrate completely. The routine surface pretreatment before electroplating is complicated and time-consuming.

### SUMMARY OF THE INVENTION

Therefore it is a primary object of the present invention to provide a flexible printed circuit and a method for manufacturing the same that overcome the problems mentioned above.

A flexible printed circuit according to the present invention includes a flexible plastic substrate, a layer of functionalized graphene-based ink attached to a surface of the flexible plastic substrate according to a conductive trace pattern of a circuit, and deposited copper deposited on and attached to a surface of the functionalized graphene-based ink.

A method for manufacturing flexible printed circuits according to the present invention includes the steps of preparing a functionalized graphene-based ink, printing the functionalized graphene-based ink on a surface of a flexible plastic substrate by screen printing to form a conductive trace pattern of a circuit, drying the functionalized graphene-based ink on the surface of the flexible plastic substrate at a temperature between 60°C and 200°C, and immersing the flexible plastic substrate with the functionalized graphene-based ink on the surface thereof into a chemical plating solution so as to form a layer of deposited copper on a surface of the functionalized graphene-based ink by chemical copper plating.

Preferably, the flexible plastic substrate can be made from polyimide, polyester, epoxy, fluorocarbon films or aramid papers.

Preferably, the functionalized graphene-based ink includes at least modified graphene oxide (GO).

Preferably, the functionalized graphene-based ink is a mixture of functionalized graphene, dispersants, solvents, binders, and thickeners.

Preferably, the functionalized graphene-based ink further includes crosslinkers and initiators.

Preferably, the surface of the functionalized graphene is provided with one of the following functional groups- oxygen, lactol, ester, hydroxyl, epoxy, and ketone.

Preferably, the amount of oxygen in the functionalized graphene that contains oxygen groups is 5-50wt%.

Preferably, the functionalized graphene is further doped with nitrogen (N), sulfur (S), boron (B), fluorine (F), phosphorous (P) or their combinations.

Preferably, the amount of the elements or their combinations contained in the functionalized graphene is 1-20 wt%.

Preferably, the present method for manufacturing flexible printed circuits further includes a step of modifying binders, crosslinkers, monomers or polymers contained in the functionalized graphene-based ink.

Preferably, the binders, the crosslinkers, the monomers and the polymers for modification of the functionalized graphene-based ink includes at least one of the following functional groups-an amino group, a carboxyl group, a hydroxyl group, a double bond, a triple bond, and an alkyl halide group.

Preferably, the binder is made from polymer or resin. The amount of the adhesive in the functionalized graphene-based ink is 0.1-30 wt%.

Preferably, the chemical plating solution is a formaldehyde copper plating solution.

The present flexible printed circuit and the method for manufacturing the same features on that no hexavalent chromium (chromium (VI) and palladium is used as catalyst for chemical copper plating. The functionalized graphene-based ink is used as catalyst so that the present invention is cost-saving and environmentally-friendly. The conductive trace formed by the functionalized graphene-based ink has excellent adhesion and flexibility so that the conductive trace will not be broken even the flexible printed circuits are bent. The conductive trace is still attached to the surface of the flexible plastic substrate securely and used as the adhesive between the deposited copper and the flexible plastic substrate.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein:
Fig. 1 is a cross-sectional view of an embodiment of a flexible printed circuit/flexible printed circuit according to the present invention;
Fig. 2 is a flow chart showing steps of an embodiment of a method for manufacturing flexible printed circuits according to the present invention;
Fig. 3-1 and Fig. 3-2 are schematic drawings showing steps of an embodiment of a method for manufacturing flexible printed circuits according to the present invention;
Fig. 4-1 and Fig. 4-2 are schematic drawings showing cross sections of a conductive trace formed by functionalized graphene-based ink before stretch and after stretch respectively according to the present invention.

### DETAILED DESCRIPTION OF THE PREFERRED EMBODIMENT

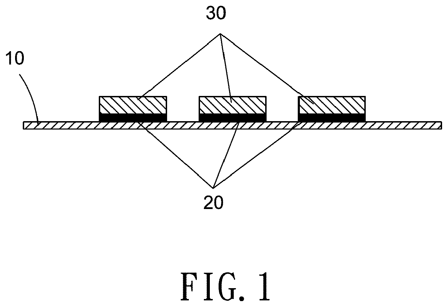

Refer to Fig. 1, a schematic drawing showing a section of an embodiment of a flexible printed circuit is revealed. In a preferred embodiment, a flexible printed circuit according to the present invention includes a flexible plastic substrate 10, a layer of functionalized graphene-based ink 20 attached to a surface of the flexible plastic substrate 10 according to a conductive trace pattern of a circuit, and deposited copper 30 deposited on and attached to a surface of the functionalized graphene-based ink 20.

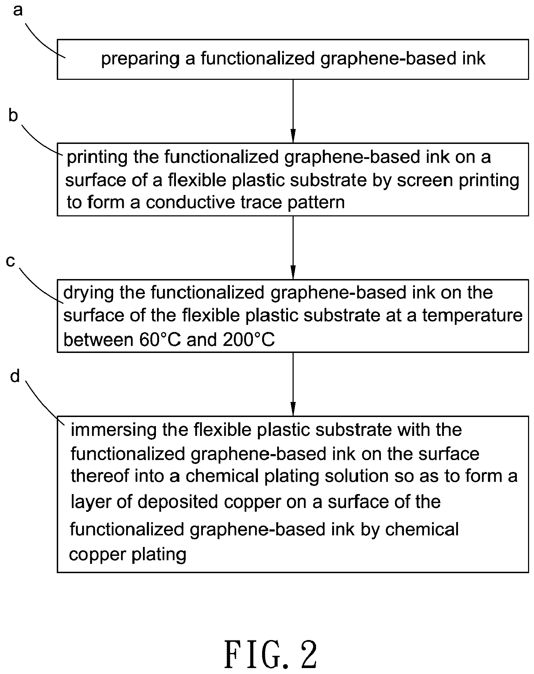

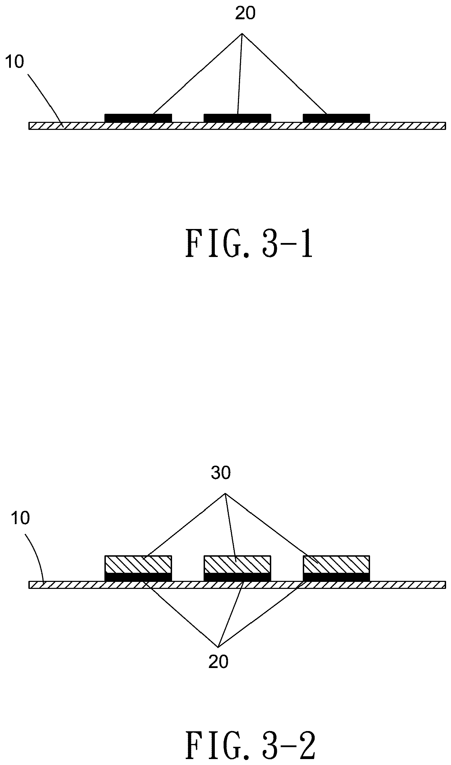

Refer to Fig. 2, a flow chart showing steps of a method for manufacturing flexible printed circuits is revealed. The method for manufacturing flexible printed circuits according to the present invention includes the following steps. (a) preparing a functionalized graphene-based ink 20; (b) printing the functionalized graphene-based ink 20 on a surface of a flexible plastic substrate 10 by screen printing to form a conductive trace pattern of a circuit (whose cross-sectional structure is shown in Fig. 3-1); (c) drying the functionalized graphene-based ink 20 on the surface of the flexible plastic substrate 10 at a temperature between 60 degrees Celsius (°C) and 200°C; and (d) immersing the flexible plastic substrate 10 with the functionalized graphene-based ink 20 on the surface thereof into a chemical plating solution so as to form a layer of deposited copper 30 (whose cross-sectional structure is shown in Fig. 3-2) on a surface of the functionalized graphene-based ink 20 by chemical copper plating. The chemical plating solution is a formaldehyde copper plating solution.

In a preferred embodiment, materials for the flexible plastic substrate 10 include polyimide, polyester, epoxy, fluorocarbon films and aramid papers.

The functionalized graphene-based ink 20 consists of functionalized graphene, dispersants, solvents, binders 41 and thickeners. In a preferred embodiment of the present invention, the functionalized graphene-based ink 20 further includes crosslinkers 41 and initiators. In a preferred embodiment, the amount of the functionalized graphene is 0.5-30wt%. The amount of the dispersants is 0.05-20wt% and the dispersants can be ionic or non-ionic. The amount of the solvents is 30-90 wt% and the solvents can be organic solvents, inorganic solvents or aqueous solvents. The binder 41 is resin, polymer or their combinations. It should be noted that the use of the polymer or resin as the binder 41 is not necessary when graphene flake materials 40 or graphene oxides are used as catalyst. The amount of the thickeners is 0.01-10wt% and the functionalized graphene-based ink 20 with high viscosity can be produced by the thickeners.

The functionalized graphene contained in the functionalized graphene-based ink 20 is a kind of modified graphene oxide (GO) obtained by surface modification of GO. In a preferred embodiment, the surface of the GO (preferably a graphene flake material 40) is modified so as to obtain better properties and the modified GO can be used as catalyst for electroless copper plating. In a preferred embodiment of the modified GO, a surface of the functionalized graphene includes one of the followings-oxygen, lactol, ester, hydroxyl, epoxy, and ketone. The amount of oxygen in the functionalized graphene that contains oxygen groups is 5-50wt%.

In another preferred embodiments, the functionalized graphene is further doped with nitrogen (N), sulfur (S), boron (B), fluorine (F), phosphorous (P) or their combinations. The amount of the elements or their combinations contained in the functionalized graphene is 1-20 wt%.

In a preferred embodiment, a method for manufacturing flexible printed circuits according to the present invention further includes a step of modifying binders 41, crosslinkers 41, monomers or polymers of the functionalized graphene-based ink 20. In other words, the functionalized graphene-based ink 20 is modified through the binders 41, the crosslinkers 41, the monomers or the polymers contained therein.

The binders 41, the crosslinkers 41, the monomers and the polymers used for modification of the functionalized graphene-based ink 20 includes at least one of the following functional groups-an amino group, a carboxyl group, a hydroxyl group, a double bond, a triple bond, and an alkyl halide group. The binder 41 is made from polymer or resin. The amount of the adhesive in the functionalized graphene-based ink 20 is 0.1-30 wt%.

The present invention provide an efficient, cost-saving, and environmentally-friendly flexible printed circuit and a method for manufacturing the same in which no heavy metals are used as catalysts for electroless copper plating. In a preferred embodiment, graphene is functionalized with oxygen to become a functionalized graphene containing oxygen groups. Then the functionalized graphene containing oxygen groups is mixed with the dispersants, solvents, binders 41, thickeners, crosslinkers 41 and initiators mentioned above for preparation of the above functionalized graphene-based ink 20.

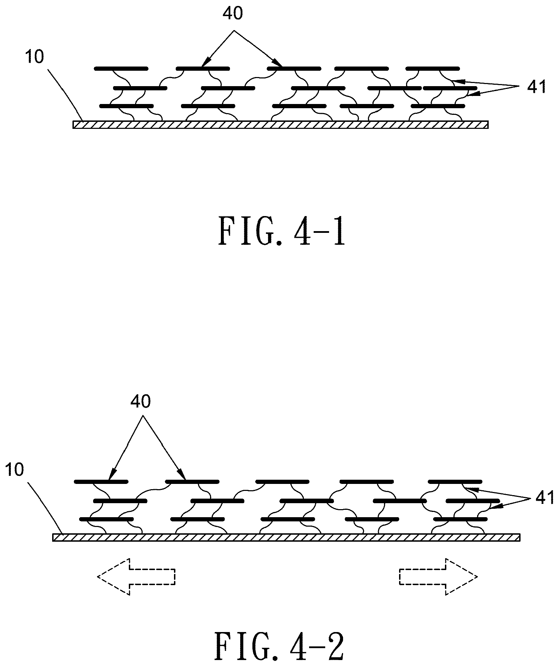

Fig. 4-1 and Fig. 4-2 are cross sections of a conductive trace formed by the functionalized graphene-based ink 20 before stretch and after stretch respectively, showing the function of the present flexible printed circuit. In an embodiment, graphene flake materials 40 are selected and used as the functionalized graphene in the functionalized graphene-based ink 20. In Fig. 4-1, a multiple-layer structure is formed by graphene flake materials 40. The conductive trace pattern formed by the functionalized graphene-based ink 20 will not be broken before stretch and after stretch owing to the binder 41 and/or the crosslinker 41 between the two adjacent layers of the graphene flake materials 40. Thereby the functionalized graphene-based ink 20 can be attached to the surface of the flexible plastic substrate 10 firmly and used as the adhesive between the deposited copper 30 and the flexible plastic substrate 10.

### Embodiment 1

In an embodiment, polyimide film (PI film) is used as the flexible plastic substrate 10. Then the functionalized graphene-based ink 20 is printed on a surface of the PI film by screen printing to form a conductive trace pattern of a circuit. Next the PI film with the functionalized graphene-based ink 20 is dried in the oven at 100°C for 20 minutes. After drying, the PI film with the functionalized graphene-based ink 20 printed on the surface thereof is placed in a 50 °C -70 °C formaldehyde copper plating solution for 30-120 minutes. Thus a layer of uniform deposited copper 30 is formed on the surface of the functionalized graphene-based ink 20 and used as the conductive trace.

Additional advantages and modifications will readily occur to those skilled in the art. Therefore, the invention in its broader aspects is not limited to the specific details, and representative devices shown and described herein. Accordingly, various modifications may be made without departing from the spirit or scope of the general inventive concept as defined by the appended claims and their equivalent.

## Claims

1. A flexible printed circuit comprising:
a flexible plastic substrate (10);
a layer of functionalized graphene-based ink (20) attached to a surface of the flexible plastic substrate (10) according to a conductive trace pattern of a circuit; and
deposited copper (30) deposited on and attached to a surface of the functionalized graphene-based ink (20).

2. The flexible printed circuit as claimed in claim 1, wherein a material for the flexible plastic substrate (10) is selected from the group consisting of polyimide, polyester, epoxy, fluorocarbon films and aramid papers.

3. The flexible printed circuit as claimed in claim 1, wherein functionalized graphene-based ink (20) includes at least modified graphene oxide (GO).

4. The flexible printed circuit as claimed in claim 1, wherein the functionalized graphene-based ink (20) includes functionalized graphene, dispersants, solvents, binders (41), and thickeners.

5. The flexible printed circuit as claimed in claim 4, wherein the functionalized graphene-based ink (20) further includes crosslinkers (41) and initiators.

6. The flexible printed circuit as claimed in claim 4, wherein a surface of the functionalized graphene is provided with a functional group selected from the group consisting of oxygen, lactol, ester, hydroxyl, epoxy, and ketone.

7. The flexible printed circuit as claimed in claim 6, wherein the amount of oxygen in the functionalized graphene that contains oxygen is 5-50wt%.

8. The flexible printed circuit as claimed in claim 6, wherein the functionalized graphene is further doped with a substance selected from the group consisting of nitrogen (N), sulfur (S), boron (B), fluorine (F), phosphorous (P) and a combination thereof.

9. The flexible printed circuit as claimed in claim 8, wherein the amount of the substance contained in the functionalized graphene is 1-20 wt%.

10. The flexible printed circuit as claimed in claim 5, wherein the functionalized graphene-based ink (20) is modified through a substance selected from the group consisting of the binders (41), the crosslinkers (41), monomers and polymers.

11. The flexible printed circuit as claimed in claim 10, wherein the binders (41), the crosslinkers (41), the monomers and the polymers used for modifying the functionalized graphene-based ink (20) includes at least one functional group selected from the group consisting of an amino group, a carboxyl group, a hydroxyl group, a double bond, a triple bond, and an alkyl halide group.

12. The flexible printed circuit as claimed in claim 4, wherein the binder (41) is made from polymer or resin and the amount of the binder (41) in the functionalized graphene-based ink (20) is 0.1-30 wt%.

13. A method for manufacturing the flexible printed circuit according to anyone of claims 1 to 11, the method comprising the steps of:
preparing a functionalized graphene-based ink (20);
printing the functionalized graphene-based ink (20) on a surface of a flexible plastic substrate (10) by screen printing to form a conductive trace pattern of a circuit;
drying the functionalized graphene-based ink (20) on the surface of the flexible plastic substrate (10) at a temperature between 60°C and 200°C; and
immersing the flexible plastic substrate (10) with the functionalized graphene-based ink (20) on the surface thereof into a chemical plating solution so as to form a layer of deposited copper (30) on a surface of the functionalized graphene-based ink (20) by chemical copper plating.

14. The method as claimed in claim 13, wherein the method further includes a step of modifying the functionalized graphene-based ink (20) through a substance that is contained in the functionalized graphene-based ink (20) and selected from the group consisting of the binders (41), the crosslinkers (41), monomers and polymers.

15. The method as claimed in claim 13, wherein the chemical plating solution is a formaldehyde copper plating solution.
